# EUROPÄISCHE PATENTSCHRIFT

(11) **EP 1 160 887 B1**
(45) Veröffentlichungstag und Bekanntmachung des Hinweises auf die Patenterteilung: **19.12.2007**
(21) Anmeldenummer: 01110573.1
(22) Anmeldetag: 30.04.2001
(51) Int. Cl.: H01L 43/04

(54) **Halleffekt-Sensorelement mit integrierten Kondensatoren**
Hall-effect sensor element with integrated condensers
Capteur à effet Hall avec des condensateurs integrés

(30) Priorität: 15.05.2000 US 570717
(43) Veröffentlichungstag der Anmeldung: 05.12.2001
(73) Patentinhaber: Siemens VDO Automotive Corporation, Auburn Hills, Michigan 48326 (US)
(72) Erfinder: Opie, John, Stony Creek, CT 06405 (US)
(74) Vertreter: Kley, Hansjörg

(56) Entgegenhaltungen:
- US-A- 5 059 746
- US-A- 5 822 849
- PATENT ABSTRACTS OF JAPAN Bd. 1999, Nr. 09, 30. Juli 1999 (1999-07-30) -& JP 11 097276 A (NIPPON CHEMICON CORP), 9. April 1999 (1999-04-09)
- PATENT ABSTRACTS OF JAPAN Bd. 012, Nr. 456 (P-793), 30. November 1988 (1988-11-30) -& JP 63 179201 A (NIPPON DENSO CO LTD), 23. Juli 1988 (1988-07-23)
- PATENT ABSTRACTS OF JAPAN Bd. 1995, Nr. 06, 31. Juli 1995 (1995-07-31) -& JP 07 065906 A (MATSUSHITA ELECTRIC IND CO LTD), 10. März 1995 (1995-03-10)

## Beschreibung

Die vorliegende Erfindung betrifft eine Hallelement- und Kondensatoranordnung gemäss dem Oberbegriff des Patentanspruches 1.

Die Erfindung betrifft insbesondere verbesserte Bauformen und Verfahren zur Ausbildung von Halleffekt-Sensorelementen mit integrierten EMI-Abschirmungskondensatoren.

Elektronische Sensoren werden verbreitet in einer Vielzahl von Anwendungen benutzt. Die Nachfrage und Verwendung dieser Sensoren wächst derzeit rapide. Wie bei den meisten elektronischen Geräten besteht ein ständig wachsender Bedarf für vereinfachte Fertigungsverfahren sowie eine Verminderung der physischen Größe der Gerätebaueinheiten. Typische Halleffekt-Sensorelemente überwinden derzeit Probleme, die mit elektromagnetischer Störung (EMI) und elektrostatischer Entladung (ESD) verknüpft sind, durch die Verwendung von Ableitkondensatoren, die mit den Halleffekt-Sensorelementen auf geeignete Weise verknüpft sind. Bei diesen bekannten Konstruktionen werden Kondensatoren durch ein Löt-, Schweißverfahren etc. angeschlossen, um eine bei der Herstellung von Automobilsensoren oder anderen Sensoren zu verwendende Funktionsuntergruppe zu bilden.

Bei diesen bekannten Fertigungsverfahren ist es notwendig, dass eine Vorrichtung oder eine Person jede der Komponenten während des Anschlußverfahrens präzise ergreift und positioniert. Typischerweise werden Epoxidmantel-Kondensatoren mit radialer Zuleitung für die gewünschte Baugruppenmontage ausgewählt. Die vergleichsweise große Abmessung dieser Komponenten und ihre oft irreguläre Körperform haben zur Folge, dass sie alles andere als optimal sind, um die Ziele einer Verbesserung des Fertigungsverfahrens und einer Minimierung der Gesamtgröße der Sensorbaugruppe zu erreichen. Außerdem werden, hinsichtlich des Leistungsvermögens, EMI-Unterdrückung und ESD-Schutz erhöht, wenn die Kondensatoren physisch näher an dem Hallelement positioniert werden, als es bei dieser Art einer Kondensatorbaugruppe möglich ist.

Aufgrund der durch die großen Kondensatorkörper auferlegten Begrenzungen, ist die Fähigkeit, die erwünschten Ergebnisse zu erzielen, bei diesen früheren Systemen begrenzt. Obschon derzeit viel kleinere Kondensatorbaugruppen verfügbar sind, ist ihre Größe für die Anlagen der Sensormontageverfahren nicht angemessen und ihre zerbrechliche Bauform erfordert Schutzmaßnahmen gegenüber einer Beschädigung bei der nachfolgenden Verarbeitungen der Gesamtbaugruppe. Existierende Baugruppenlösungen besitzen somit durch ihre derzeitige Voraussetzung, ihre relativ großen Epoxidmantel-Kondensatoren mit radialen Zuleitungen zu verwenden, Einschränkungen.

Dementsprechend besteht auf diesem Fachgebiet weiterhin Bedarf, die Fertigungsverfahren für Halleffekt-Sensorbaugruppen durch eine Verkleinerung der physischen Größe der Gesamtbaugruppe zu verbessern. Zusätzlich besteht auf diesem Fachgebiet weiterhin Bedarf, das mit Halleffekt-Baugruppen verknüpfte Fertigungsverfahren zu verbessern.

In US 5,822,849 [1] ist ein Verfahren zur Herstellung einer wasserfesten Hallelement- und Kondensatoranordnung offenbart, bei dem die Komponenten über elektrisch leitende koplanare Teile miteinander verbunden werden. Dabei ist ein Träger («integral structural member») für das Eingiessen eines isolierenden Materials vorgesehen, so dass die einzelnen Teile durch das Eingiessen eines isolierenden Materials die Teile positioniert bzw. in ihrer Position sichert und durch den Träger verschiedene getrennte Komponenten gebildet werden. Diese an und für sich zweckmässige Anordnung ist relativ aufwendig in der Herstellung.

Der vorliegenden Erfindung liegt daher die Aufgabe zugrunde, eine Hallelement- und Kondensatoranordnung anzugeben, die mit geringerem Aufwand hergestellt werden kann und eine geringere Komplexität aufweist.

Diese Aufgabe wird durch die im Patentanspruch 1 angegebenen Merkmale gelöst.

Vorteile der vorliegenden Erfindung werden aus der folgenden Zusammenfassung und ausführlichen Beschreibung der bevorzugten Ausführungsformen deutlich werden.

Um die Größe der Gesamtbaugruppe des Halleffekt-Sensorelements zu verkleinern und das Fertigungsverfahren zu verbessern, werden gemäß der vorliegenden Erfindung zuleitungslose chipartige Kondensatoren als EMI-Abschirmungs-/ESD-Schutz-Ableitungskondensatoren verwendet. Die oben identifizierten Probleme, die mit der Verwendung dieser kleineren Komponenten verknüpft waren, werden bei einer Ausführungsform der vorliegenden Erfindung durch die Verwendung einer Baugruppe mit Träger überwunden. Bei einer alternativen Ausführungsform, wird eine isolierte, in Form hergestellte Einkapselung angewendet und umgibt den Chipkondensator und die Verbindungen zu dem Halleffektsensor.

Bei einer als Beispiel dienenden ersten Ausführungsform der vorliegenden Erfindung, stellt eine in Form hergestellte Trägerstruktur ein Gehäuse für die Montage eines Hallzellenelements sowie eines oder mehrerer EMI-Abschirmungs-/ESD-Schutz-Ableitungskondensatoren bereit. Das Trägergehäuse erleichtert die Verbindung der Hallzelle und des Chipkondensators. Diese Bauform vereinfacht zusätzlich das Fertigungsverfahren zum Anschließen der kleineren Chipkondensator-Komponenten.

Bei einer als Beispiel dienenden Ausführungsform ist die Hallzelle in sich ausstreckenden Armen des Trägergehäuses eingebettet. Zuleitungen aus der Hallzelle werden in den Hohlräumen des Trägers aufgenommen und ein oder mehrere Chipkondensatoren werden in einem weiteren, in dem Trägergehäuse ausgebildeten Hohlraum aufgenommen. Das Trägergehäuse besteht aus einem in Form hergestellten isolierenden Körper, der vorzugsweise aus wärmebeständigem Kunststoff geformt ist. Obschon es nicht notwendig ist, wird es bevorzugt, dass eine Mehrzahl individueller Hohlräume ausgebildet wird, um die einfache Plazierung einer jeden individuellen Chipkondensator-Komponente zu fördern, sowie als Schutz für die gesamte Baugruppe. Die Hallzelle sowie Zuleitungen und einer oder mehrere zuleitungsfreie Chipkondensatoren werden während des Fertigungsverfahrens in ihren zugehörigen Hohlräumen des Trägergehäuses plaziert. Danach werden die notwendigen Lötverbindungen ausgebildet, um elektrische Kontakte zwischen den Hallzelle und EMI-Abschirmungs-/ESD-Schutz-Ableitkondensatoren bereitzustellen.

Bei einer alternativen Ausführungsform der Erfindung umfaßt das Chipträgergehäuse ein Federdruckelement, das einen Druck zwischen den Zuleitungen der Hallzelle und den zuleitungslosen Chipträgerelementen anlegt. Dies gewährleistet einen besseren elektrischen Kontakt zwischen den jeweiligen Elementen. Nachdem die zuleitungslosen Chipkondensatoren mit den jeweiligen Zuleitungen der Hallzelle verlötet wurden, wird ein Epoxidharz oder ein anderes isolierendes Material verwendet, um die verbleibenden Freiräume der Hohlräume zu füllen und dadurch eine haltbarere physische Baugruppe bereitzustellen.

Bei einer alternativen Ausführungsform besitzt die Hallzelle Zuleitungen, die aus ihrem Körper herausstehen und auf denen einer oder mehrere EMD-Abschirmungs-/ESD-Schutz-Ableitkondensatoren montiert sind. Die Ableitkondensatoren sind erwünschterweise zuleitungslose chipartige Kondensatoren. Sobald die zuleitungslosen chipartigen Kondensatoren mit ihren jeweiligen Zuleitungen aus der Hallzelle verlötet wurden, wird ein Epoxidharz oder eine andere isolierende Verkapselung angewandt, vorzugsweise in einer Form, um die Chipkondensatoren und Zuleitungen zu umgeben. Die Verwendung von Chipkondensatoren bei jeder Ausführungsform sorgt für eine insgesamt kleinere Baugruppe für den Halleffekt-Sensor.

### KURZE BESCHREIBUNG DER ZEICHNUNGEN

Fig. 1 veranschaulicht eine als Beispiel dienende erste Ausführungsform der Erfindung, die ein Gehäuse zur Montage des Hallsensors und der Abschirmkondensatoren einsetzt;
Fig. 2 ist eine Seitenansichtsdarstellung der in Fig. 1 gezeigten Vorrichtung;
Fig. 3 ist eine Darstellung, die eine alternative Ausführungsform der Erfindung zeigt, bei der ein isolierender Körper die auf Zuleitungen eines Hallsensors angebrachten Chip-Kondensatoren umgibt;
Fig. 4 veranschaulicht eine alternative Ausführungsform der vorliegenden Erfindung, bei der ein Trägergehäuse nur die Zuleitungen des Hallelements umgibt.

### AUSFÜHRLICHE BESCHREIBUNG DER BEVORZUGTEN AUSFÜHRUNGSFORM

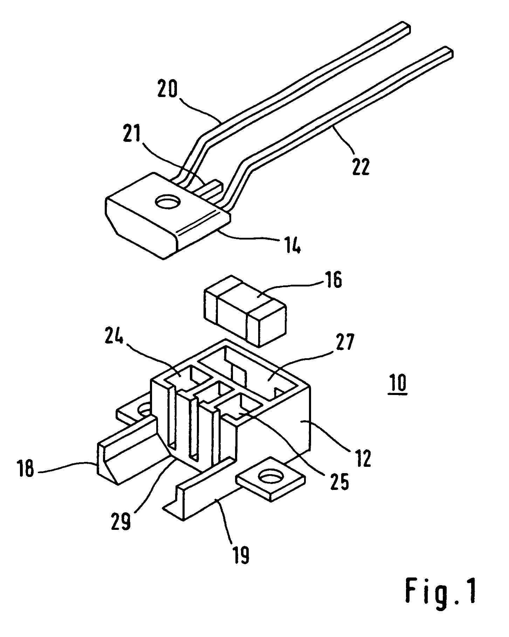

Fig. 1 veranschaulicht eine als Beispiel dienende Ausführungsform der vorliegenden Erfindung, bei der für eine Halleffekt-Sensorbaugruppe, die allgemein bei 10 gezeigt wird, zuleitungslose chipartige Kondensatoren als EMI-Abschirmungs-/ESD-Schutz- und Ableitkondensatoren verwendet werden. Die mit der Verwendung der kleineren Chipkondensator-Komponenten verknüpften Probleme werden durch die Verwendung einer Trägerbaugruppe 12 überwunden, wie sie bei dieser Ausführungsform der vorliegenden Erfindung gezeigt ist.

Bei dieser als Beispiel dienenden ersten Ausführungsform der vorliegenden Erfindung stellt die in Form hergestellte Trägerstruktur 12 ein Gehäuse für die Montage eines Hallzellenelements 14 sowie einer oder mehrerer EMI-Abschirmungs-/ESD-Schutz-oder Ableitkondensatoren 16 bereit, von denen aus Gründen der Bequemlichkeit nur einer dargestellt ist. Das Trägergehäuse 12 erleichtert die Verbindung der Hallzelle 14 und des Chipkondensators 16. Zusätzlich vereinfacht die Struktur 12 das Fertigungsverfahren für das Anschließen der kleineren zuleitungslosen Chipkondensator-Komponenten 16.

Bei dieser als Beispiel dienenden Ausführungsform ist die Hallzelle 14 in sich austreckenden Armen 18, 19 des Trägergehäuses 12 eingebettet. Zuleitungen 20, 21, 22 aus der Hallzelle 14 werden in den Hohlräumen 24, 25 des Trägers 12 aufgenommen und ein oder mehrere Chipkondensatoren 16 werden in einem weiteren, in dem Trägergehäuse 12 ausgebildeten Hohlraum 27 aufgenommen. Das Trägergehäuse 12 besteht aus einem in Form hergestellten isolierenden Körper 29, der vorzugsweise aus wärmebeständigem Kunststoff geformt ist. Obschon es nicht notwendig ist, wird es bevorzugt, dass eine Mehrzahl individueller Hohlräume ausgebildet wird, um die einfache Plazierung einer jeden individuellen Chipkondensator-Komponente zu fördern sowie als Schutz für die gesamte Baugruppe. Die Hallzelle sowie Zuleitungen und einer oder mehrere zuleitungsfreie Chipkondensatoren werden während des Fertigungsverfahrens in ihren zugehörigen Hohlräumen des Trägergehäuses plaziert. Danach werden die notwendigen Lötverbindungen ausgebildet, um elektrische Kontakte zwischen den Hallzellenzuleitungen und den EMI-Abschirmungs-/ESD-Schutz-Ableitkondensatoren 16 bereitzustellen.

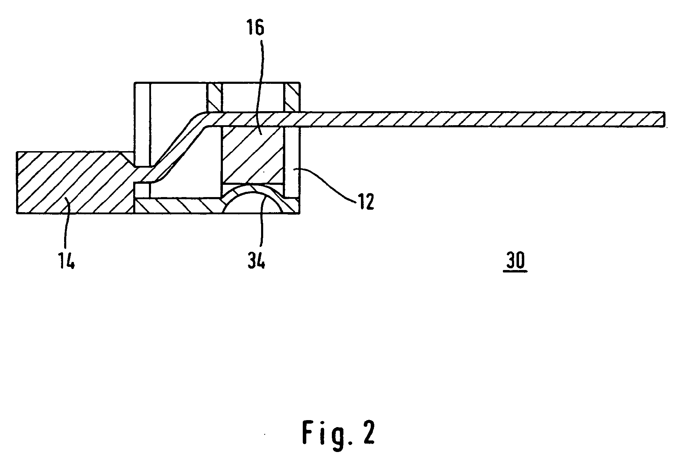

Figur 2 veranschaulicht eine bei 30 in Seitenansicht gezeigte alternative Ausführungsform der Erfindung, bei der das Chipträgergehäuse 12 ein Federdruckelement 34 umfaßt, das zwischen den Zuleitungen der Hallzelle und den zuleitungsfreien Chipträgerelementen einen Druck ausübt. Dies gewährleistet einen besseren elektrischen Kontakt zwischen den jeweiligen Elementen. Nachdem die zuleitungsfreien Chipkondensatoren mit den zugehörigen Zuleitungen der Hallzelle verlötet wurden, wird Epoxidharz oder ein anderes isolierendes Material verwendet, um die verbleibenden Freiräume der Hohlräume in dem Trägergehäuse 12 zu füllen und dadurch eine haltbarere physische Baugruppe bereitzustellen.

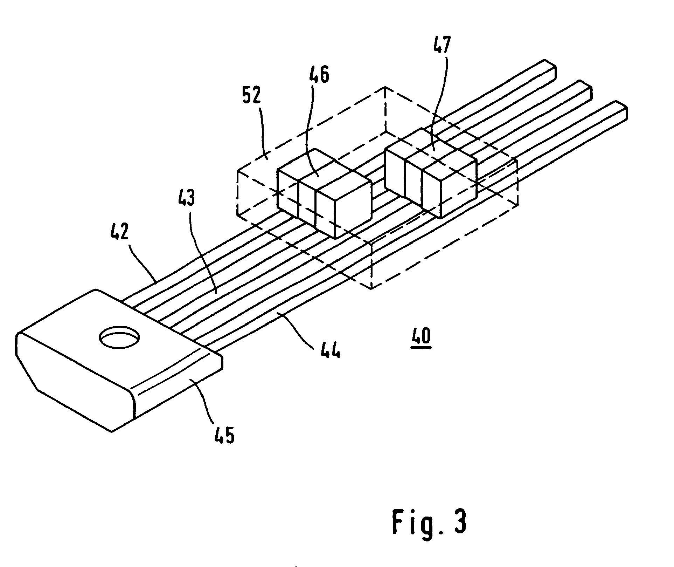

Figur 3 zeigt noch eine weitere alternative Ausführungsform, die allgemein bei 40 gezeigt ist. Bei dieser alternativen Ausführungsform, besitzt der Hallsensor Zuleitungen 42, 43, 44, die aus seinem Körper 45 herausstehen. Einer oder mehrere EMI-Abschimungs-/ESD-Schutz-Ableitkondensatoren 46, 47 sind über die Zuleitungen des Hallsensorelements 45 montiert. Die Ableitkondensatoren 46, 47 sind erwünschterweise zuleitungslose chipartige Kondensatoren. Sobald die zuleitungslosen chipartigen Kondensatoren mit ihren jeweiligen Zuleitungen zur Hallzelle verlötet wurden, wird ein Epoxidharz 52 oder eine andere isolierende Verkapselung angewandt, vorzugsweise in einer Form, um die Chipkondensatoren und Zuleitungen zu umgeben. Die Verwendung von Chipkondensatoren bei jeder Ausführungsform sorgt für eine insgesamt kleinere Baugruppe für den Halleffektsensor. Zusätzlich bieten die hier beschriebenen Bauformen und Verfahren Vorteile gegenüber den früheren Verfahren, während sie auch eine kleinere, dauerhaftere Baugruppe für die gesamte Baueinheit bereitstellen.

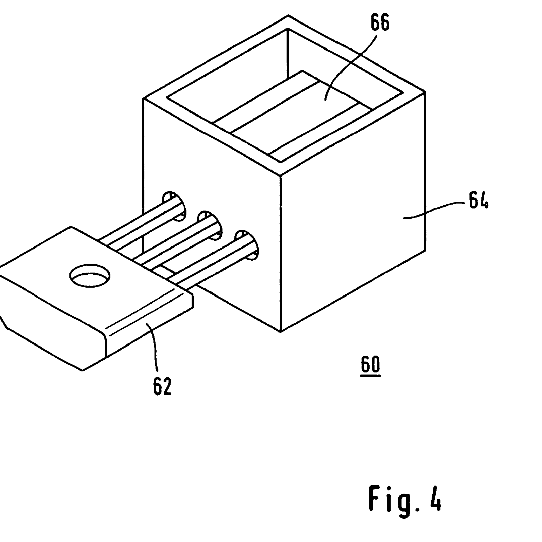

Der Fachmann wird erkennen, dass es nicht notwendig ist, das Trägergehäuse so spezifisch wie hier beschrieben auszubilden. Obschon das oben beschriebene Trägergehäuse die erwünschteste Bauform hat, kommen auch andere in Form hergestellte Trägergehäuse in Betracht, die ähnlich geeignet sind. Beispielsweise wäre jedes Gehäuse ähnlich geeignet, das einen Ort zur Plazierung des Hallzellenelements und eines oder mehrerer Chipkondensatoren bereitstellt. Es ist jedoch wünschenswert, dass der Träger einen Teil besitzt, der physisch passend ist, um den physischen Körper des Hallzellenelements wie in Fig. 1 gezeigt aufzunehmen. Es ist ähnlich wünschenswert, dass das Trägergehäuse einen Teil aufweist, der einen oder mehrere Chipkondensatoren aufnimmt. Es versteht sich jedoch, dass keines dieser wünschenswerten Merkmale erforderlich ist. Figur 4 veranschaulicht zum Beispiel ein allgemein bei 60 gezeigtes Trägergehäuse, bei dem Zuleitungen eines Hallelements 62 in einem Trägerkörper 64 aufgenommen sind, der zumindest einen Hohlraum zur Aufnahme eines Chipkondensators 66 aufweist. Sobald die Lötverbindungen hergestellt sind, kann der Hohlraum dieser Ausführungsform wie bei den oben beschriebenen früheren Ausführungsformen abgedichtet werden, um eine haltbarere Baugruppe zu schaffen.

### Bezugszeichenliste

- 10: Halleffekt Sensorbaugruppe
- 12: Trägerbaugruppe, Trägerstruktur, Trägergehäuse
- 14: Hallzellenelement, Hallzelle
- 16: Chipkondensator
- 18: Arm, Hallelementhalter
- 19: Arm, Hallelementhalter
- 20: Zuleitung
- 21: Zuleitung
- 22: Zuleitung
- 24: Hohlraum
- 25: Hohlraum
- 27: Hohlraum
- 29: isolierender Körper
- 30: Ausführungsform mit einem Federdruckelement
- 34: Federdruckelement
- 40: Ausführungsform mit herausstehenden Hallsensor-Zuleitungen
- 42: Zuleitung
- 43: Zuleitung
- 44: Zuleitung
- 45: Körper, Gehäuse des Hallelementes
- 46: Ableitungskondensator
- 47: Ableitkondensator
- 52: Epoxidharz
- 60: Ausführungsform mit einem die Zuleitungen aufnehmenden Trägerkörpers
- 62: Hallelement
- 64: Trägerkörper
- 66: Chipkondensator

### Liste der verwendeten Abkürzungen

- EMI: electromagnetic interference
- ESD: electrostatic discharge

### zitierte Druckschriften

[1] US 5,822,849
   «Hinged Circuit Assembly with Multi-conductor Framework»
   Assignee U.S. Philips Corporation, New York
   Granted Oct. 20, 1998

## Patentansprüche

1. Hallelement- und Kondensatoranordnung (10, 40, 60) umfassend:
- ein Hallelement mit einer Hallzelle (14) und aus der Hallzelle (14) herausstehenden Zuleitungen (20, 21, 22);
- ein Trägergehäuse (12) mit zumindest einem Hohlraum (24, 25, 27), in dem eine oder mehrere Zuleitungen (20, 21, 22) aus der Hallzelle (14) angeordnet sind; und
- ein Kondensator (16), der innerhalb des Hohlraums (24, 25, 27) angeordnet ist und mit dem Hallelement (14) elektrisch verbunden ist,
**dadurch gekennzeichnet, dass**
der Kondensator als zuleitungsloser Chipkondensator (16) ausgeführt ist und direkt mit einer der Zuleitungen (20, 21, 22) aus der Hallzelle (14) verbunden ist.

2. Hallelement- und Kondensatoranordnung (10, 40, 60) gemäß Anspruch 1,
**dadurch gekennzeichnet, dass**
ein zweiter zuleitungsloser Chipkondensator (16, 46, 47) vorgesehen ist, der innerhalb des Hohlraums (24, 25, 27) angeordnet ist und mit einer weiteren der Zuleitungen (20, 21, 22) aus der Hallzelle (14) verbunden ist.

3. Hallelement- und Kondensatoranordnung (10, 40, 60) gemäß Anspruch 1,
**dadurch gekennzeichnet, dass**
das Trägergehäuse (12) zwei Hallelementhalter (18, 19) aufweist, die sich vom Trägergehäuse (12) weg erstrecken und dass das Hallelement (14) in die Hallelementhalter (18, 19) eingebettet ist.

4. Hallelement- und Kondensatoranordnung (10, 40, 60) gemäß einem der Ansprüche 1 bis 3,
**dadurch gekennzeichnet, dass**
der den Chipkondensator (16) aufnehmende Hohlraum (24, 25, 27) mit einem isolierenden Material (52) gefüllt ist.

5. Hallelement- und Kondensatoranordnung (10, 40, 60) gemäß Anspruch 4,
**dadurch gekennzeichnet, dass**
das isolierende Material ein Epoxidharz (52) ist.

6. Hallelement- und Kondensatoranordnung (10, 40, 60) gemäß einem der Ansprüche 2 bis 5,
**dadurch gekennzeichnet, dass**
zwei Chipkondensatoren (16, 46, 47) zwischen den Zuleitungen (20, 21, 42, 43, 44) aus der Hallzelle (14, 45, 62) angeschlossen sind.

7. Hallelement- und Kondensatoranordnung (10, 40, 60) gemäß einem der Ansprüche 2 bis 5,
**dadurch gekennzeichnet, dass**
das Trägergehäuse (12) ein Federdruckelement (34) umfasst, das zwischen einer Zuleitung (20, 21, 22) aus der Hallzelle (14) und einem Chipkondensator (16) einen Druck ausübt.

## Claims

1. Hall element and capacitor assembly (10, 40, 60) comprising:
- a Hall element with a Hall cell (14) and electrical leads (20, 21, 22) projecting from said Hall cell (14),
- a carrier housing (12) having at least one cavity (24, 25, 27) within which one or more leads (20, 21, 22) from the Hall cell (14) are located, and
- a capacitor (16) which is located within said cavity (24, 25, 27) and is electrically connected to the Hall element (14),
**characterised in that**
the capacitor is implemented as a leadless chip capacitor (16) and is connected directly to one of the leads (20, 21, 22) from the Hall cell (14).

2. Hall element and capacitor assembly (10, 40, 60) according to claim 1,
**characterised in that**
a second leadless chip capacitor (16, 46, 47) is provided which is located within the cavity (24, 25, 27) and is connected to another one of the leads (20, 21, 22) from the Hall cell (14).

3. Hall element and capacitor assembly (10, 40, 60) according to claim 1,
**characterised in that**
the carrier housing (12) has two Hall element supports (18, 19) which extend from said carrier housing (12) and that the Hall element (14) is cradled in the Hall element supports (18, 19).

4. Hall element and capacitor assembly (10, 40, 60) according to one of claims 1 to 3,
**characterised in that**
the cavity (24, 25, 27) receiving the chip capacitor (16) is filled with an insulating material (52).

5. Hall element and capacitor assembly (10, 40, 60) according to claim 4,
**characterised in that**
the insulating material is an epoxy resin (52).

6. Hall element and capacitor assembly (10, 40, 60) according to one of claims 2 to 5,
**characterised in that**
two chip capacitors (16, 46, 47) are connected between the leads (20, 21, 42, 43, 44) from the Hall cell (14, 45, 62).

7. Hall element and capacitor assembly (10, 40, 60) according to one of claims 2 to 5,
**characterised in that**
the carrier housing (12) includes a spring pressure element (34) which applies pressure between a lead (20, 21, 22) from the Hall cell (14) and a chip capacitor (16).

## Revendications

1. Dispositif (10, 40, 60) à élément de Hall et à condensateur comprenant :
- un élément de Hall ayant une cellule (14) de Hall et des lignes (20, 21, 22) d'entrée partant de la cellule (14) de Hall,
- un boîtier (12) support ayant au moins une cavité (24, 25, 27) dans laquelle sont disposées une ou plusieurs lignes (20, 21, 22) d'entrée provenant de la cellule (14) de Hall ; et
- un condensateur (16) qui est disposé à l'intérieur de la cavité (24, 25, 27) et qui et relié électriquement à l'élément (14) de Hall;
**caractérisé en ce que**
le condensateur est réalisé en condensateur (16) puce sans ligne d'entrée et est relié directement à l'une des lignes (20, 21, 22) d'entrée provenant de la cellule (14) de Hall.

2. Dispositif (10, 40, 60) à élément de Hall et à condensateur suivant la revendication 1,
**caractérisé en ce que**
il est prévu un deuxième condensateur (16, 46, 47) puce sans ligne d'entrée, qui est disposé dans la cavité (24, 25, 27) et qui est relié à une autre des lignes (20, 21, 22) d'entrée provenant de la cellule (14) de Hall.

3. Dispositif (10, 40, 60) à élément de Hall et. à condensateur suivant la revendication 1,
**caractérisé en ce que**
le boîtier (12) support a deux pièces (18, 19) de maintien d'un élément de Hall qui s'éloigne du boîtier (12) support et **en ce que** l'élément (14) de Hall est incorporé dans les pièces (18, 19) de maintien d'un élément de Hall.

4. Dispositif (10, 40, 60) à élément de Hall et à condensateur suivant l'une des revendications 1 à 3,
**caractérisé en ce que**
la cavité (24, 25, 27) recevant le condensateur (16) puce est emplie d'un matériau (52) isolant.

5. Dispositif (10, 40, 60) à élément de Hall et à condensateur suivant la revendication 4,
**caractérisé en ce que**
le matériau isolant est une résine (52) époxyde.

6. Dispositif (10, 40, 60) à élément de Hall et à condensateur suivant l'une des revendications 2 à 5,
**caractérisé en ce que**
deux condensateurs (16, 46, 47) puce sont raccordés entre les lignes (20, 21, 42, 43, 44) d'entrée provenant de la cellule (14, 45, 62) de Hall.

7. Dispositif (10, 40, 60) à élément de Hall et à condensateur suivant l'une des revendications 2 à 5,
**caractérisé en ce que**
le boîtier (12) support comprend un élément (34) d'application d'un ressort qui applique une pression entre une ligne (20, 21, 22) d'entrée provenant de la cellule (14) de Hall et un condensateur (16) puce.
